Europäisches Patentamt

European Patent Office

Office européen des brevets

(11) Veröffentlichungsnummer: **0 297 235**

**A1**

(12) **EUROPÄISCHE PATENTANMELDUNG**

(21) Anmeldenummer: 88106466.1

(22) Anmeldetag: 22.04.88

(51) Int. Cl.⁴: **C23C 14/34 , C23C 14/36**

(30) Priorität: 29.06.87 DE 3721373

(43) Veröffentlichungstag der Anmeldung:
04.01.89 Patentblatt 89/01

(84) Benannte Vertragsstaaten:
**AT BE CH DE FR GB IT LI NL**

(71) Anmelder: **LEYBOLD AKTIENGESELLSCHAFT**
**Wilhelm-Rohn-Strasse 25**
**D-6450 Hanau 1(DE)**

(72) Erfinder: **Hubert, Peter**
**Elzestrasse 12**
**D-8755 Alzenau(DE)**
Erfinder: **Kussel, Barbara, Dr.**
**Maistrasse 14**
**D-6054 Rodgau 1(DE)**
Erfinder: **Wirz, Peter, Dr.**
**Klosterstrasse 5**
**D-6296 Waldernbach(DE)**

(54) Beschichtungsvorrichtung.

㊝ Um bei einer Kathodenzerstäubungsvorrichtung eine möglichst gleichmäßige Ausnutzung des Targets (1) und eine qualitativ hochwertige Schicht auf dem Substrat zu erzeugen, ist die Kathode auf ihrer dem Substrat abgewandten Seite des Targets (1) mit einer ebenen Platte (2) versehen, auf der eine Vielzahl von Magneten (3 bis 6) in Reihen angeordnet sind, wobei die Magnete (3 bis 6) der einzelnen zueinander parallelen Reihen etwa gleiche Abstände (a) und gleiche Polarität zueinander aufweisen. Außerdem sind die Magnete der einen Reihe zu den Magneten der benachbarten Reihe jeweils um ein Maß (g) versetzt angeordnet, so daß sich im Bereich des mit dem Beschichtungsmaterial versehenen Targets (1) bei Verwendung der Kathode in einem Rezipienten mit geeignetem Gasdruck und bei angelegter Spannung beliebiger Frequenz Plasmaschläuche (12 bis 15) ausbilden, die schlangenförmig gekrümmten Rennbahnen gleichen.

FIG.1

## Beschichtungsvorrichtung

Die Erfindung betrifft eine Beschichtungsvorrichtung mit hoher Zerstäubungs- oder Depositionsrate, mit einer Magneteinrichtung, bei der von der Kathodenfläche ausgehende und zu ihr zurückkehrende Magnetfeldlinien in Verbindung mit einem elektrischen Feld einen Entladungsbereich bilden.

Es ist bereits eine Kathodenzerstäubungsvorrichtung mit hoher Zerstäubungsrate bekannt (DPS 24 17 288), bei der die zu zerstäubende und dem zu besprühenden Substrat zugewandte Kathode plattenförmig ausgebildet ist, so daß sich das Substrat nahe dem Entladungsbereich parallel zu der ebenen Zerstäubungsfläche über dieses hinwegbewegen läßt, wobei die das Magnetfeld erzeugende Magneteinrichtung auf der der ebenen Zerstäubungsfläche abgewandten Seite der Kathode angeordnet ist.

Diese bekannt Kathode hat jedoch den Nachteil, daß sich bei sehr großen Substraten, beispielsweise bei Fensterscheiben, keine wirklich befriedigende Gleichmäßigkeit der Schicht auf dem Substrat erzielen läßt. Darüberhinaus ist die Abnutzung des Targets derart, daß nur ein relativ geringer Anteil des auf dem Target befindlichen zu zerstäubenden Materials dem Schichtaufbau auf dem Substrat zugute kommt, da die Zerstäubung des Materials an eng begrenzten Partien der plattenförmigen Targets sehr intensiv und an benachbarten Partien nahezu überhaupt nicht erfolgt.

Aufgabe der vorliegenden Erfindung ist es, die Standzeit des Targets und damit den Abtrag des Target-Materials zu verbessern und eine weitgehend gleichmäßige Beschichtung auch von besonders großflächigen Substraten zu ermöglichen. Weiterhin soll im Falle eines Plasma unterstützten CVD-Prozesses eine gute Schichtdicken-Gleichmäßigkeit auf dem Substrat erzielt werden.

Erfindungsgemäß wird dies dadurch erreicht, daß auf der dem Substrat abgekehrten Seite einer ersten Platte und parallel zu ihr eine zweite Platte angeordnet ist, auf der zwei oder mehr Reihen mit jeweils mehreren Magneten mit gleicher Polarität gehalten sind, wobei die Magnete der einen Reihe zu den Magneten der benachbarten Reihe jeweils versetzt zueinander angeordnet sind, und wobei die Magnete jeweils einer Reihe etwa den gleichen Abstand zueinander aufweisen. Anstelle von Reihen von Magneten, die parallel zueinander angeordnet sind, können gemäß der Erfindung auch Magnete vorgesehen sein, deren Abstände zueinander verschieden sind; ebenso können anstelle einer einzigen parallel zur ersten Platte angeordenten Platte auch mehrere Platten vorgesehen sein.

In einer besonders preiswerten Ausführungsform sind die Magnete als Permanentmagnete ausgebildet und auf der das zu zerstäubende Material aufweisenden Platte zugewandten Oberseite einer zweiten Platte angeordnet, wobei der jeweilige magnetische Gegenpol eines Magneten von der zweiten Platte gebildet ist, derart, daß die Feldlinien senkrecht aus der Oberseite der zweiten Platte aus- bzw. eintreten, wobei der Abstand zwischen zwei benachbarten Magneten so bemessen ist, daß die gegenseitige Abstoßung der gleichnamigen Pole in diesem Zwischenraum gegenüber der Anziehung der zweiten Platte überwiegt.

Zweckmäßigerweise weisen die auf der zweiten Platte fest angeordneten Permanentmagnete eine stabförmige Konfiguration auf, wobei die einzelnen Magnete mit einer rechteckigen Seitenfläche derart unverschiebbar mit der zweiten Platte verbunden sind, daß der magnetische Pol der das zerstäubbare Material tragenden Platte zugekehrt ist.

Vorzugsweise sind die die Magneten tragende zweite Platte und/oder die das zu zerstäubende Material aufweisende erste Platte von einem etwa kasten- oder rahmenförmigen, eine Dunkelraum-Abschirmung bildenden Blechabdeckung umgriffen, wobei zwischen der Blechabdeckung und den Platten ein elektrischer Isolator oder ein isolierender Spalt vorgesehen ist.

Mit Vorteil sind die die Magnete aufweisende zweite Platte und/oder die Blechabdeckung mit Durchbrüchen oder Bohrungen für elektrische Verbindungsleitungen versehen.

Um eine möglichst gleichmäßige Abnutzung des Targets zu gewährleisten, wird durch die Anordnung der beiden benachbarten Platten in einem Rezipienten mit geeignetem Gasdruck und bei angelegter Kathodenspannung beliebiger Frequenz an jeder Reihe von Magneten ein - schlangenförmiger Plasmaschlauch ausgebildet, wobei die Plasmaschläuche zweier Magnetreihen eine schlangenförmig gewundene Rennbahn bilden.

Schließlich kann die zweite mit Magneten bestückte Platte gegenüber ihrer Halterung oder der Dunkelraumabschirmung beweglich, beispielsweise um eine lotrechte Achse rotierbar sein.

Die Erfindung läßt die verschiedensten Ausführungsformen zu; eine davon ist in den anhängenden Zeichnungen schematisch näher dargestellt und zwar zeigen:

Fig. 1 die perspektivische Darstellung einer Kathode, deren schlangenförmige Plasmaschläuche als punktierte Felder angedeutet sind und die im übrigen nur abschnittsweise dargestellt ist,

Fig. 2 eine Draufsicht auf eine mit vier Reihen von Magneten versehene Platte,

Fig. 3 einen Teilschnitt quer durch die beiden benachbarten Platten der Kathode gemäß Fig. 1, von denen die eine einen Magneten trägt und die andere das zu zerstäubende Material, wobei der Verlauf der Magnetlinien mit Hilfe einiger Pfeile angedeutet ist,

Fig. 4 die perspektivische Ansicht eines Abschitts der die Magnete tragenden Platte, wobei der Verlauf der Magnetlinien durch Pfeile angedeutet ist.

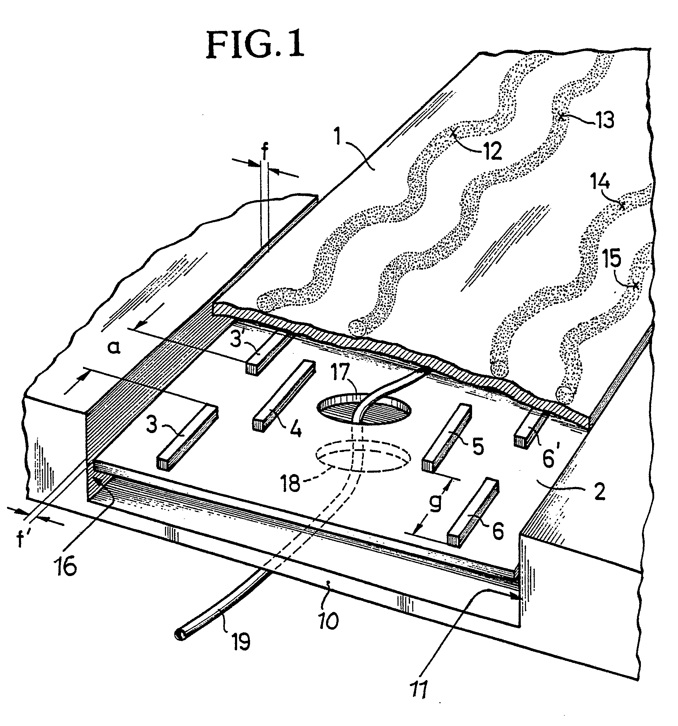

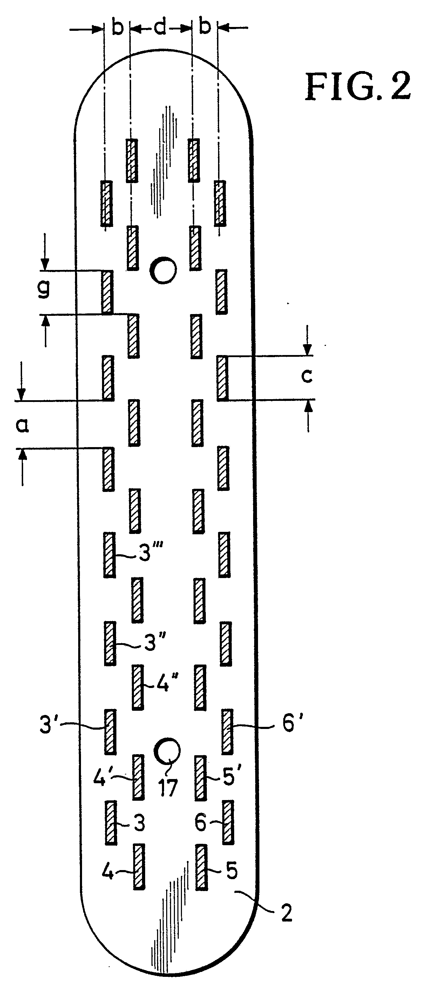

Die in Fig. 1 dargestellte Kathode ist im Innenraum einer Vakuumkaßmer angeordnet und ist dazu an einem nicht näher dargestellten Tragrohr gehalten, das seinerseits mit dem Deckelteil der Vakuumkamßer isoliert verbunden ist. Der das Substrat oder Werkstück haltende Werkstückhalter ist der Kathode gegenüberliegend vorgesehen und seinerseits an der Basisplatte der Vakuumkammer abgestützt. Schließlich ist eine Anode vorhanden, die als isoliert gehaltener Ring ausgebildet ist, und der die Kathode zumindest teilweise umschließt. Die in den Figuren 1 bis 4 näher dargestellte Kathode besteht im wesentlichen aus einer ersten Platte 1, auf der sich das zu zerstäubende Material befindet, und die damit das sogenannte Target bildet. Parallel zur Platte 1 ist ein Magnethalter in Form einer zweiten Platte 2 angeordnet, auf deren Vorderseite eine Vielzahl von stabförmigen Permanentmagneten 3, 4 bzw. 5, 6 vorgesehen sind. Die einzelnen Magnete sind in insgesamt vier nebeneinanderliegenden Reihen angeordnet, wobei die Magnete 3, 3', 3'' usw. eine erste Reihe, die Magnete 4, 4', 4'' usw. eine zweite Reihe, die Magnete 5, 5', 5'' usw. eine dritte Reihe und die Magnete 6, 6', 6'' usw. eine vierte Reihe bilden. Die einzelnen Magnete 3', 3'', 4'' ... der ersten Reihe sind in gleichmäßigen Abständen a zueinander angeordnet, wobei die einzelnen Magnete 4, 4' ... der zweiten Reihe einerseits die gleichen Abstände a zueinander aufweisen, andererseits jedoch jeweils in Längsrichtung der Platte 2 gesehen um eine Magnetlänge c verschoben angeordnet sind. In dem in den Figuren 1 bis 4 dargestellten Falle ist der Abstand a im übrigen so gewählt, daß er der Länge c eines Magneten 3 bis 6 entspricht, während der Abstand b, den die erste Reihe mit den Magneten 3, 3' ... zur zweiten Reihe mit den Magneten 4, 4' aufweist, geringer gewählt ist. Schließlich ist der Abstand d, den die zweite Reihe zur dritten Reihe mit den Magneten 5, 5' aufweist, erheblich größer bemessen, als der Abstand b, den die beiden Reihen 1 und 2 zueinander haben.

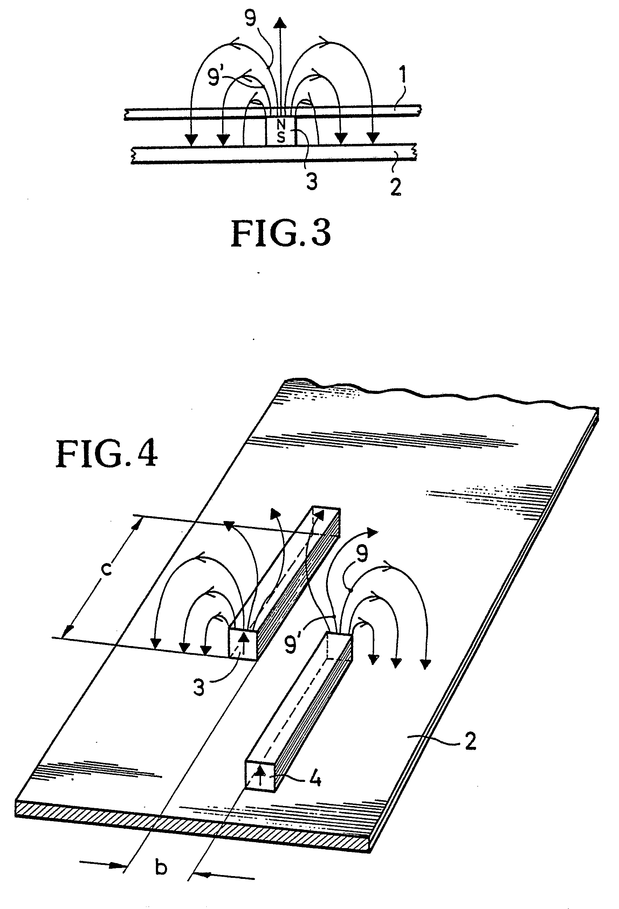

Wie aus den Abbildungen gut ersichtlich ist, sind die Stabmagnete 3 bis 6 so ausgerichtet, daß ihre Polarität stets gleich ist, so daß die Feldlinien 9, 9' ... senkrecht aus der Oberseite der ersten Platte 1 ausbzw. eintreten, wobei der Abstand b zwischen zwei benachbarten Magneten so bemessen ist (Fig. 4), daß die gegenseitige Abstoßung der gleichnamigen Pole in diesem Zwischenraum gegenüber der zweiten Platte 2 überwiegt. Beide Platten 1, 2 sind teilweise von einer Dunkelraumabschirmung 10 umgriffen.

Die Kathoden-Dunkelraumabschirmung 10 weist ebenso wie die Platten 1, 2 eine im allgemeinen rechteckige Form auf und ist mit einem Umfangsflansch 16 ausgestattet, der sich (Fig. 1) nach oben zu erstreckt und den Umfang der Kathode umgibt. Die Abschirmung 10, 11, 16 ist im Abstand f, f' zu den beiden Platten 1, 2 bzw. zum Target und zum Magnethalter angebracht, wobei die hierzu erforderlichen Abstandshalter und Isolierstücke in den Figuren nicht näher dargestellt sind. In Fig. 1 sind die sich während des Zerstäubungsvorgangs, des sogenannten Sputterns, bildenden Plasmaschläuche 12, 13 bzw. 14, 15 angedeutet, die schlangenförmig gekrüßmmten Rennbahnen gleichen. Da mehrere derartige Rennbahnen oberhalb eines Targets vorgesehen sein können und die Länge der Rennbahnen durch deren - schlangenförmigen Verlauf vergrößert wird, eignet sich die beschriebene Kathode in hervorragender Weise zur Beschichtung von großflächigen Werkstücken oder Substraten. Das Ergebnis ist eine völlig gleichmäßige Schichtdicke, die außerdem noch vergleichsweise rasch aufbringbar ist und deren Haftvermögen ungewöhnlich gut ist.

Mit der beschriebenen Vorrichtung kann das Beschichten von plattenförmigen Substraten sehr wirtschaftlich durchgeführt werden, indem die Substrate sehr nahe an dem Entladungsbereich parallel zur Targetoberfläche an der Targetoberfläche entlangbewegt werden. Hierbei wird eine hohe Ablagerungsrate pro Watt auch bei großflächigen Substraten erzielt. Weil das Target eben ausgebildet, die Anordnung der Anode verhältnismäßig unkritisch, die das Magnetfeld erzeugende Einrichtung auf der vom Substrat abgewandten Seite des Targets angeordnet ist und die Rennbahnen so gelegt werden können, daß einander überlappende Bereiche gleich intensiver Zerstäubung entstehen, kann dem Entladungsbereich eine beliebige, entsprechend der Form des zu beschichtenden Substrats gewünschte Konfiguration gegeben werden. So können ohne weiteres lange, schmale Kathodenoberflächen mit entsprechend langen und schmalen Entladungsbereichen verwirklicht werden, um breite, sich senkrecht zur Längserstreckung der Kathodenoberfläche bewegende Substrate mit einem Minimum an Platzaufwand zu beschichten. Da die Entladungsverhältnisse von der Zahl, der Größe und Anordnung der Magnete bestimmt sind, wird trotz der Größe der Kathode eine äußerst gleichmäßige Ablagerung erzielt.

Die ebenen Kathoden bewirken aber nicht nur eine sehr wirtschaftliche Substratbeschichtung, sondern sind auch relativ einfach herzustellen, was besonders dann wichtig ist, wenn spröde und schwer zu bearbeitende Materialien für die Kathode verwendet werden. Außerhalb der Vakuumkaßmer und seitlich des Substrates angeordnete Magnetspulen können bei der beschriebenen Kathodenzerstäubungsvorrichtung vermieden werden. Im Inneren der Vakuumkammer unmittelbar hinter der Kathode angeordnete Spulen oder Permanentmagnete sind nicht nur wesentlich platzsparender unterzubringen, sondern gewährleisten auch höhere Feldstärken mit geringeren Strömen.

## Auflistung der Einzelteile

1 erste Platte, Target
2 zweite Platte, Target
3 Stabmagnet, Permanentmagnet
4 Stabmagnet, Permanentmagnet
5 Stabmagnet, Permanentmagnet
6 Stabmagnet, Permanentmagnet
7 Stabmagnet, Permanentmagnet
8 Stabmagnet, Permanentmagnet
9 Feldlinie
10 Dunkelraumabschirmung
11 Umfangsflansch
12 Plasmaschlauch
13 Plasmaschlauch
14 Plasmaschlauch
15 Plasmaschlauch
16 Umfangsflansch
17 Durchbruch, Bohrung
18 Durchbruch, Bohrung
19 elektrische Verbindungsleitung

## Ansprüche

1. Beschichtungsvorrichtung mit hoher Zerstäubungs- oder Depositionsrate mit einer Magneteinrichtung, bei der von der Kathodenfläche ausgehende und zu ihr zurückkehrende Magnetfeldlinien in Verbindung mit einem elektrischen Feld einen Entladungsbereich bilden, dadurch gekennzeichnet, daß auf der dem Substrat abgekehrten Seite einer ersten Platte (1) und parallel zu ihr eine zweite Platte (2) angeordnet ist, auf der zwei oder mehr einander parallele Reihen mit jeweils mehreren Magneten (3 bis 6) mit gleicher Polarität gehalten sind, wobei die Magnete (3 bis 6) der einen Reihe zu den Magneten der benachbarten Reihe (um das Maß g) versetzt zueinander angeordnet sind und wobei die Magnete jeweils einer Reihe etwa den gleichen Abstand (a) zueinander aufweisen.

2. Beschichtungsvorrichtung mit hoher Zerstäubungs- oder Depositionsrate mit einer Magneteinrichtung, bei der von der Kathodenfläche ausgehende und zu ihr zurückkehrende Magnetfeldlinien in Verbindung mit einem elektrischen Feld einen Entladungsbereich bilden, dadurch gekennzeichnet, daß auf der dem Substrat abgekehrten Seite einer ersten Platte und parallel zu ihr weitere Platten angeordnet sind, auf der Magnete gehalten sind, wobei die Magnete verschieden große Abstände zueinander und gleiche Polarität aufweisen.

3. Beschichtungsvorrichtung nach Anspruch 1 oder 2, dadurch gekennzeichnet, daß die Magnete (3 bis 6) als Permanentmagnete ausgebildet sind und auf der das zu zerstäubende Material aufweisenden oder das aus der Gasphase zu beschichtende Substrat tragenden Platte (1) zugewandten Oberseite einer zweiten Platte (2) angeordnet sind, wobei der jeweilige magnetische Gegenpol eines Magneten von einer zweiten Platte (2) gebildet ist, derart, daß die Feldlinien senkrecht aus der Oberseite der ersten Platte (1) aus- bzw. eintreten, wobei der Abstand (b) zwischen zwei benachbarten Magneten (3, 4 bzw. 5, 6) so bemessen ist, daß die gegenseitige Abstoßung der gleichnamigen Pole in diesem Zusaßmenhang gegenüber der Anziehung der zweiten Platte (2) überwiegt.

4. Beschichtungsvorrichtung nach den Ansprüchen 1 bis 3, dadurch gekennzeichnet, daß die auf einer zweiten Platte (2) fest angeordneten Permanentmagnete (3 bis 6) eine stabförmige Konfiguration aufweisen, wobei die einzelnen Magnete mit einer rechteckigen Seitenfläche derart unverschiebbar mit der zweiten Platte (2) verbunden sind, daß der magnetische Pol der das zerstäubende Material tragenden Platte (1) zugekehrt ist.

5. Beschichtungsvorrichtung nach einem der vorhergehenden Ansprüche, dadurch gekennzeichnet, daß die die Magneten (3 bis 6) tragende zweite Platte (2) und/oder die das zu zerstäubende Material aufweisende erste Platte (1) von einem etwa kasten- oder rahmenförmigen, eine Dunkelraum-Abschirmung (10) bildende geerdeten Blechabdeckung umgriffen sind, wobei zwischen der Blechabdekkung und den Platten (1, 2) ein elektrischer Isolator oder ein isolierender Spalt (f, f´) vorgesehen ist.

6. Beschichtungsvorrichtung nach einem oder mehreren der vorhergehenden Ansprüche, dadurch gekennzeichnet, daß die die Magnete (3 bis 6) aufweisende Platte (2) und/oder die Blechabdeckung (10) Durchbrüche oder Bohrungen (17, 18) für elektrische Verbindungsleitungen (19) aufweist.

7. Beschichtungsvorrichtung nach einem oder mehreren der vorhergehenden Ansprüche, dadurch gekennzeichnet, daß sich durch die Anordnung der beiden benachbarten Platten (1, 2) in einem Rezipienten mit geeignetem Gasdruck und bei angelegter Kathoden-Spannung beliebiger Frequenz jeweils um zwei Reihen von benachbarten Magneten (3 bis 6) ein schlangenförmiger Plasmaschlauch (12 bis 15) ausbildet, wobei die Plasmaschläuche (12 bis 15) zweier Magnetreihen eine schlangenförmig gewundene, geschlossene Rennbahn bilden.

8. Beschichtungsvorrichtung nach einem oder mehreren der vorhergehenden Ansprüche, dadurch gekennzeichnet, daß die zweite, mit Magneten bestückte Platte gegenüber ihrer Halterung oder ihrer Dunkelraum-Abschirmung beweglich ist, beispielsweise um eine lotrechte zur zweiten Platte verlaufenden Achse drehbar ist.

9. Beschichtungsvorrichtung nach einem oder mehreren der vorhergenannten Ansprüche, dadurch gekennzeichnet, das zumindest einer der auf einer zweiten Platte fest angeordneten Permanentmagnete eine ringförmige Konfiguration aufweist.

# FIG.1

FIG.2

EP 0 297 235 A1

FIG.3

FIG.4

## EINSCHLÄGIGE DOKUMENTE

EP 88106466.1

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE - A1 - 3 530 074 (SIEMENS AG) <br> * Fig.; Anspruch * <br> -- | 1 | C 23 C 14/34 <br><br> C 23 C 14/36 |
| A | DE - A1 - 3 527 626 (LEYBOLD-HERAEUS GMBH) <br> * Fig. 1-3,5,7; Anspruch 1 * <br> -- | 1 | |
| A | DE - A1 - 3 434 698 (THE UNIVERSITY OF BRITISH COLUMBIA) <br> * Fig.; Ansprüche * <br> -- | 1 | |
| A | DD - A3 - 230 565 (J.HAPTUNG, K. GOEDICKE, U.HEISIG, S.SCHILLER, G. BEISTER, H.C.HECHT, W.HEMPEL, G. KÜHN, V.SPREITZ) <br> * Fig.; Anspruch * <br> -- | 1 | |
| A | PATENT ABSTRACTS OF JAPAN, unexamined applications, C Field, Band 10, Nr. 245, 22. August 1986 <br><br> THE PATENT OFFICE JAPANESE GOVERNMENT <br> Seite 128 C 368 <br> * Kokai-Nr. 61-76 671 (NEC CORP.) * <br> -- | 1 | |

RECHERCHIERTE SACHGEBIETE (Int. Cl.4)

C 23 C

Der vorliegende Recherchenbericht wurde für alle Patentansprüche erstellt.

| Recherchenort | Abschlußdatum der Recherche | Prüfer |
|---|---|---|
| WIEN | 21-09-1988 | SLAMA |

-2-
EP 88106466.1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PATENT ABSTRACTS OF JAPAN, unexamined applications, C Field, Band 10, Nr. 185, 27. Juni 1986 <br><br> THE PATENT OFFICE JAPANESE GOVERNMENT <br> Seite 104 C 357 <br><br> * Kokai-Nr. 61-34 177 (TOKUDA SEISAKUSHO LTD.) * <br><br> ---- | 1 | |
| | | | RECHERCHIERTE SACHGEBIETE (Int. Cl.4) |

Der vorliegende Recherchenbericht wurde für alle Patentansprüche erstellt.

| Recherchenort | Abschlußdatum der Recherche | Prüfer |
|---|---|---|
| WIEN | 21-09-1988 | SLAMA |